Europäisches Patentamt

European Patent Office

Office européen des brevets

(11) Veröffentlichungsnummer: **0 256 368 B1**

(12) **EUROPÄISCHE PATENTSCHRIFT**

(45) Veröffentlichungstag der Patentschrift: **30.09.92**

(21) Anmeldenummer: **87110884.1**

(22) Anmeldetag: **27.07.87**

(51) Int. Cl.⁵: $G01R\ 1/073$

(54) **Prüfeinrichtung für beidseitige, zweistufige Kontaktierung bestückter Leiterplatten.**

(30) Priorität: **07.08.86 DE 3626758**

(43) Veröffentlichungstag der Anmeldung:
**24.02.88 Patentblatt  88/08**

(45) Bekanntmachung des Hinweises auf die
Patenterteilung:
**30.09.92 Patentblatt  92/40**

(84) Benannte Vertragsstaaten:
**BE DE FR GB IT SE**

(56) Entgegenhaltungen:
**EP-A- 0 196 149**
**DE-B- 2 657 910**
**DE-C- 3 511 821**
**US-A- 4 115 735**
**US-A- 4 335 350**

(73) Patentinhaber: **SIEMENS AKTIENGESELL-
SCHAFT
Wittelsbacherplatz 2
W-8000 München 2(DE)**

(72) Erfinder: **Hilz, Wolfgang
Schulstrasse 43
W-8000 München 19(DE)**
Erfinder: **Schuster, Rudolf, Dipl.-Ing.
Graf-Andechs-Strasse 8
W-8011 Heimstetten(DE)**
Erfinder: **Schauflinger, Hans
Mauthäuslstrasse 39
W-8000 München 70(DE)**

**Beschreibung**

Die Erfindung betrifft eine Prüfeinrichtung für bestückte Leiterplatten mittels beidseitiger, jeweils zweistufiger Kontaktierung.

Für die elektrische Prüfung bestückter Leiterplatten, die auch als Flachbaugruppen bezeichnet werden können, sind Nadeladapter mit prüflingsspezifisch angeordneten Kontaktstiften im Einsatz. Man unterscheidet dabei zwischen Schaltkreistest oder Funktions- bzw. Teilfunktionstest. Bei der Prüfung wird die bestückte Leiterplatte mit der Lötseite gegen im Nadeladapter angeordnete, gefederte Kontaktnadeln gedrückt. Soll nun in derselben Prüfeinrichtung sowohl ein Schaltkreistest als auch ein Funktions- bzw. Teilfunktionstest durchgeführt werden, so ist eine zweistufige Kontaktierung mit unterschiedlich langen Kontaktnadeln vorzusehen. In der ersten Stufe der Kontaktierung kommen beim Funktions- bzw. Teilfunktionstest dann nur die langen Kontaktnadeln zum Eingriff, während in der zweiten Stufe der Kontaktierung beim Schaltkreistest die kurzen Kontaktnadeln hinzutreten.

Die DE-C-35 11 821 zeigt und beschreibt eine Prüfeinrichtung für beidseitige, zweistufige Kontaktierung bestückter Leiterplatten, mit einem ersten Nadeladapter, der prüflingsspezifisch angeordnete und zur zweistufigen Kontaktierung der einen Seite der Leiterplatten unterschiedlich lange, erste und zweite gefederte Kontaktnadeln trägt, und mit einem zweiten Nadeladapter, der prüflingsspezifisch angeordnete und zur zweistufigen Kontaktierung der anderen Seite der Leiterplatten unterschiedlich lange, dritte und vierte gefederte Kontaktnadeln trägt. Zum Ausgleich der Druckkräfte bei ungleichmäßiger Verteilung der Kontaktnadeln auf den Nadeladaptern können Druckausgleichselemente auf den Nadeladaptern vorgesehen sein. Die Prüfung erfolgt in zwei Kontaktierstufen, wobei in der ersten Kontaktierstufe die Nadeladapter synchron aufeinander zu verschoben werden, bis jeweils die längeren Kontaktnadeln an der zu prüfenden Leiterplatte zur Anlage kommen. Danach werden die Nadeladapter noch weiter aufeinander zu verschoben, bis auch die kürzeren Kontaktnadeln in der zweiten Kontaktierstufe zur Anlage kommen.

Im Zuge der sich immer mehr durchsetzenden SMD-Technologie wird die Forderung nach einer beidseitigen, jeweils zweistufigen Kontaktierung immer mehr erhoben werden.

Das zur Kontaktierung erforderliche Andrücken der bestückten Leiterplatten kann über entsprechend verteilte Andruckstößel mechanisch vorgenommen werden. Häufiger im Einsatz sind jedoch sog. Vakuumadapter, bei denen die bestückte Leiterplatte manuell auf ein Dichtgummi gelegt und durch Erzeugung eines Vakuums angedrückt wird. Bei derartigen Vakuumadaptern stehen dem Vorteil einer besseren Zugänglichkeit an der Bauteileseite gleich mehrere Nachteile gegenüber. Da eine optimale Dosierung des Vakuums nicht möglich ist, können durch den hohen Flächendruck auftretende unzulässig hohe Durchbiegungen der Leiterplatten nicht sicher vermieden werden. Außerdem stellt die Abdichtung ein erhebliches Problem dar, so daß eine sichere Kontaktierung häufig nur durch Nachdrücken an bestimmten Stellen oder andere zusätzliche manuelle Eingriffe gewährleistet werden kann. Weiterhin ist das Spektrum der für die Prüfung im Vakuumadapter geeigneten Leiterplatten begrenzt, da beispielsweise keine offenen Durchkontaktierungen und Durchbrüche vorhanden sein sollen. Im Hinblick auf eine Automatisierung der Endprüfung bestückter Leiterplatten treten die vorstehend genannten Probleme noch stärker hervor. Insbesondere die Kontaktiersicherheit würde durch zusätzlich auftretende Dichtprobleme bei einem automatischen Wechsel der Leiterplatten weiter herabgesetzt.

Der Erfindung liegt die Aufgabe zugrunde, eine Prüfeinrichtung für bestückte Leiterplatten mittels beidseitiger, jeweils zweistufiger Kontaktierung in vier aufeinanderfolgenden Kontaktierstufen zu schaffen, die bei automatisierungsfreundlichem Aufbau und ohne die Gefahr unzulässig hoher Durchbiegungen der Leiterplatten eine hohe Kontaktiersicherheit gewährleistet. Außerdem soll die Prüfeinrichtung den Anforderungen der SMD-Technologie gerecht werden.

Diese Aufgabe wird durch die Merkmale des Anspruchs 1 gelöst.

Die erfindungsgemäße Prüfeinrichtung ermöglicht somit eine beidseitig, jeweils zweistufige Kontaktierung bestückter Leiterplatten in vier aufeinanderfolgenden Kontaktierstufen, die insbesondere durch die mechanische Einspannung der Leiterplatten zwischen oberen und unteren Andruckstößeln realisiert wird. Die Fixierung der Leiterplatte ist unabhängig von Anzahl und Verteilung der Kontaktnadeln in jeder Kontaktierstufe gegeben, wodurch der Kontaktierzustand zu jedem Zeitpunkt eindeutig definiert ist. Die Andruckstößel sind dabei Bestandteil der prüflingsspezifisch austauschbaren Nadeladapter der Prüfeinrichtung.

Gemäß einer bevorzugten Ausgestaltung der Erfindung ist der untere Nadeladapter ortsfest angeordnet. Da der untere Nadeladapter somit auch beim Kontaktiervorgang nicht bewegt wird, kann die elektrische Prüfsicherheit hier auch nicht durch eine bewegte Verdrahtung beeinträchtigt werden.

Eine weitere vorteilhafte Ausgestaltung der Erfindung sieht vor, daß die Leiterplatten mit federnd ausgebildeten oberen Andruckstößeln gegen den ortsfest angeordneten unteren Nadeladapter drückbar sind, wobei die Kräfte der federnden oberen Andruckstößel in der Summe größer sind als die Summe der Federkräfte der dritten und vierten Kontaktnadeln. Durch diese Maßnahme ist zu jedem Zeitpunkt das Kräfteverhältnis gewahrt und der Kontaktierzustand eindeutig definiert.

Der obere Nadeladapter ist vorzugsweise in vertikaler Richtung verstellbar angeordnet. In diesem Fall können dann die federnden oberen Andruckstößel fest im oberen Nadeladapter angeordnet werden. Der obere Nadeladapter und die oberen Andruckstößel können somit über einen gemeinsamen Antrieb bewegt werden.

Gemäß einer weiteren Ausgestaltung der Erfindung ist vorgesehen, daß die unteren Andruckstößel in vertikaler Richtung in zwei Stufen verstellbar sind. Durch diese zweistufige Verstellbarkeit wird die zweistufige Kontaktierung der Plattenunterseite auf besonders einfache Weise realisiert. Dabei sind die unteren Andruckstößel vorzugsweise im unteren Nadeladapter geführt und über eine untere gemeinsame Druckplatte betätigbar. Bei einem prüflingsspezifischen Austausch des unteren Nadeladapters mit den unteren Andruckstößeln können dann die Druckplatte und deren Antrieb stets in der Prüfeinrichtung verbleiben.

Eine genaue und besonders einfache Positionierung der Leiterplatten wird schließlich dadurch erreicht, daß im oberen Nadeladapter mindestens zwei den oberen Andruckstößeln vorauseilende Zentrierstifte angeordnet sind.

Ein Ausführungsbeispiel der Erfindung ist in der Zeichnung dargestellt und wird im folgenden näher beschrieben.

Es zeigen

Fig. 1 eine Prüfeinrichtung für beidseitige zweistufige Kontaktierung bestückter Leiterplatten in stark vereinfachter schematischer Darstellung und

Fig. 2 die einzelnen Stufen der Kontaktierung der Prüfeinrichtung gemäß Fig. 1.

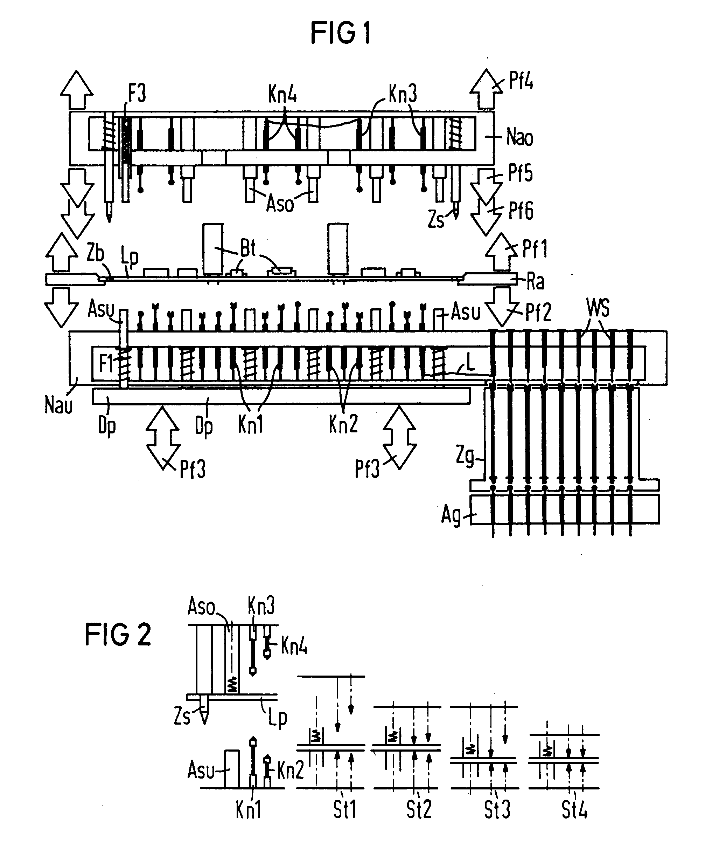

Fig. 1 zeigt eine mit verschiedenen Bauteilen Bt bestückte Leiterplatte Lp, die in einen äußeren Rahmen Ra eingelegt ist. Pfeile Pf1 und Pf2 zeigen an, daß der Rahmen Ra in vertikaler Richtung nach oben und unten beweglich ist, wobei diese Beweglichkeit von Rahmen Ra und Leiterplatte Lp beispielsweise durch eine federnde Aufhängung realisiert werden kann.

Unterhalb der Leiterplatte Lp befindet sich ein ortsfest angeordneter unterer Nadeladapter Nau, der erste gefederte Kontaktnadeln Kn1 und etwas kürzere zweite gefederte Kontaktnadeln Kn2 trägt. An einer Stelle ist angedeutet, daß die Kontaktnadeln Kn1 und Kn2 über Leitungen L mit zugeordneten Wrap-Stacheln WS verbunden sind. Die außerhalb des Kontaktierungsbereichs im unteren Nadeladapter Nau angeordneten Wrap-Stacheln WS sind ihrerseits über ein Zwischenglied Zg mit nicht näher bezeichneten federnden Nadeln mit den ebenfalls nicht näher bezeichneten Nadeln eines Anschlußgliedes Ag verbunden. Dieses Anschlußglied Ag ist Teil des eigentlichen Prüfautomaten, bei welchem es sich beispielsweise um die "Series 700" der Firma Factron-Schlumberger, Albert Schweitzer Str. 66, D-8000 München 83 handeln kann.

Im unteren Nadeladapter Nau sind ferner mit Asu bezeichnete untere Andruckstößel geführt, die über Federn F1 in vertikaler Richtung beweglich im Nadeladapter Nau gehalten sind. Die unteren Andruckstößel Asu sind also nicht federnd ausgebildet, sondern über eine gemeinsame untere Druckplatte Dp in vertikaler Richtung in zwei Stufen verstellbar. Diese durch Doppelpfeile Pf3 aufgezeigte zweistufige Verstellbarkeit kann beispielsweise durch unter der Druckplatte Dp angeordnete pneumatisch oder hydraulisch betätigbare Verstellzylinder realisiert werden.

Über der Leiterplatte Lp befindet sich ein in vertikaler Richtung verstellbar angeordneter oberer Nadeladapter Nao, der dritte gefederte Kontaktnadeln Kn3 und etwas kürzere vierte gefederte Kontaktnadeln Kn4 trägt. Die nicht näher dargestellte Weiterverdrahtung der Kontaktnadeln Kn3 und Kn4 umfaßt Übergabekontakte zum unteren Nadeladapter Nau, so daß die zahlenmäßig meist nur wenigen oberen Prüfkontakte ebenfalls über die Schnittstelle des Zwischengliedes Zg an den Prüfautomaten angeschlossen sind.

Im oberen Nadeladapter Nao sind mit Aso bezeichnete obere Andruckstößel fest angeordnet. Diese oberen Andruckstößel Aso sind teleskopartig federnd ausgebildet, wobei diese federnde Ausgestaltung an einer Stelle durch eine entsprechende Feder F3 aufgezeigt ist. Zwei ebenfalls im oberen Nadeladapter Nao angeordnete Zentrierstifte Zs haben die Aufgabe in zugeordnete Zentrierbohrungen der Leiterplatte Lp einzudringen und damit die Leiterplatte Lp genau zu positionieren.

Die vertikale Verstellbarkeit des oberen Nadeladapters Nao ist durch Pfeile Pf4, Pf5 und Pf6 aufgezeigt, wobei die beiden nach unten gerichteten Pfeile Pf5 und Pf6 die Zweistufigkeit der Kontaktierung symbolisieren sollen. Die vertikale Verstellung kann beispielsweise dadurch realisiert werden, daß der obere Nadeladapter Nao in einem massiven Vier-Säulengestell geführt und je nach Adaptergröße durch ein bis vier mittels Zahnriemen synchronisierte Spindeln über einen Gleichstrommotor angetrieben wird. Der geschilderte Antrieb der Andruckmechanik ist dabei als programmierbare Positionierachse ausgeführt.

Nachfolgend wird unter Hinzuziehung des in Fig. 2 dargestellten Kontaktierschemas ein bevorzugtes Ausführungsbeispiel für die Reihenfolge der Kontaktierung der Leiterplatte Lp in der in Fig. 1 dargestellten Prüfeinrichtung beschrieben. Auf der linken Seite der Fig. 1 sind dabei in stark vereinfachter Darstellung ein unterer Andruckstößel Asu, untere erste und zweite Kontaktnadeln Kn1 bzw. Kn2, ein Teil der zu kontaktierenden Leiterplatte Lp, ein oberer Andruckstößel Aso, ein Zentrierstift Zs und obere dritte und vierte Kontaktnadeln Kn3 bzw. Kn4 aufgezeigt. Es ist dabei eine Stellung im Anfangsstadium des Kontaktierhubes des oberen Nadeladapters Nao dargestellt, in welcher die Zentrierstifte Zs in die zugeordneten Zentrierbohrungen Zb der Leiterplatte Lp eingedrungen sind und auch die gefederten oberen Andruckstößel Aso bereits an der Leiterplatte Lp anliegen. Rechts von dieser Darstellung sind mit dem nur noch durch Pfeile angedeuteten Kontaktnadeln die vier aufeinanderfolgenden Kontaktierstufen St1, St2, St3 und St4 aufgezeigt.

In der ersten Kontaktierstufe St1 erfolgt die Kontaktierung der Unterseite der Leiterplatte Lp durch die ersten Kontaktnadeln Kn1. Die unteren Andruckstößel Asu wirken hier praktisch als Anschlag, der den Abwärtshub der Leiterplatte Lp begrenzt. Die Leiterplatte Lp ist dabei fest zwischen den unteren Andruckstößeln Asu und den oberen Andruckstößeln Aso eingespannt, d.h. der Kontaktierzustand der Kontaktierstufe St1 ist eindeutig definiert.

In der zweiten Kontaktierstufe St2 haben die im oberen Nadeladapter Nao angeordneten oberen Andruckstößel Aso so weit federnd nachgegeben, daß nun auch eine sichere Kontaktierung der Oberseite der Leiterplatte Lp durch die dritten Kontaktnadeln Kn3 vorliegt.

In der dritten Kontaktierstufe St3 nimmt die Druckplatte Dp ihre durch die Abwärtsrichtung der Pfeile Pf3 angedeutete untere Lage ein. Durch die entsprechend tiefere Lage der unteren Andruckstößel Asu und der Leiterplatte Lp ist nunmehr eine sichere Kontaktierung der Plattenunterseite durch die zweiten Kontaktnadeln Kn2 gewährleistet.

In der vierten Kontaktierstufe St4 ist schließlich durch eine weitere Abwärtsbewegung des oberen Nadeladapters Nao bei gleichzeitigem weiteren federnden Nachgeben der oberen Andruckstößel Aso eine Kontaktierung der Plattenoberseite durch die vierten Kontaktnadeln Kn4 eingetreten.

Es ist zu erkennen, daß nicht nur in der ersten Kontaktierstufe St1, sondern auch in den folgenden Kontaktierstufen St2, St3 und St4 durch eine feste Einspannung der Leiterplatte Lp zwischen den unteren und oberen Andruckstößeln Asu bzw. Aso jeweils eindeutig definierte Kontaktierzustände gewährleistet sind. Es ist ferner zu erkennen, daß für die Reihenfolge der Kontaktierungen etliche Variationen möglich sind.

**Patentansprüche**

1. Prüfeinrichtung für bestückte Leiterplatten (Lp) mittels beidseitiger, jeweils zweistufiger Kontaktierung in vier aufeinanderfolgenden Kontaktierstufen (St 1, St 2, St 3, St 4), mit
   - einem unteren Nadeladapter (Nau), der prüflingsspezifisch angeordnete und zur zweistufigen Kontaktierung der Unterseiten der Leiterplatten (Lp) unterschiedlich lange, erste und zweite gefederte Kontaktnadeln (Ku 1, Ku 2) trägt,
   - einem oberen Nadeladapter (Nao), der prüflingsspezifisch angeordnete und zur zweistufigen Kontaktierung der Oberseiten der Leiterplatten (Lp) unterschiedlich lange dritte und vierte gefederte Kontaktnadeln (Ku 3, Ku 4) trägt,
   - mehreren prüflingsspezifisch angeordneten unteren Andruckstößeln (Asu) und mit
   - mehreren prüflingsspezifisch angeordneten oberen Andruckstößeln (Aso), wobei
   - die Leiterplatten (Lp) zwischen den unteren Andruckstößeln (Asu) und den oberen Andruckstößeln (Aso) eingespannt sind.

2. Prüfeinrichtung nach Anspruch 1, dadurch **gekennzeichnet,** daß der untere Nadeladapter (Nau) ortsfest angeordnet ist.

3. Prüfeinrichtung nach Anspruch 2, dadurch **gekennzeichnet,** daß die Leiterplatten (Lp) mit federnd ausgebildeten oberen Andruckstößeln (Aso) gegen den ortsfest angeordneten unteren Nadeladapter (Nau) drückbar sind, wobei die Kräfte der federnden oberen Andruckstößel (Aso) in der Summe größer sind als die Summe der Federkräfte der dritten und vierten Kontaktnadeln (Kn3, Kn4).

4. Prüfeinrichtung nach einem der vorhergehenden Ansprüche, dadurch **gekennzeichnet,** daß der obere Nadeladapter (Nao) in vertikaler Richtung verstellbar angeordnet ist.

5. Prüfeinrichtung nach den Ansprüchen 3 und 4, dadurch **gekennzeichnet,** daß die federnden oberen Andruckstößel (Aso) fest im oberen Nadeladapter (Nao) angeordnet sind.

6. Prüfeinrichtung nach einem der vorhergehenden Ansprüche, dadurch **gekennzeichnet,** daß die unteren Andruckstößel (Asu) in vertikaler Richtung in zwei Stufen verstellbar sind.

7. Prüfeinrichtung nach Anspruch 6, dadurch **gekennzeichnet,** daß die unteren Andruckstößel (Asu) im unteren Nadeladapter (Nau) geführt und über eine untere gemeinsame Druckplatte (Dp) betätigbar sind.

8. Prüfeinrichtung nach einem der vorhergehenden Ansprüche, dadurch **gekennzeichnet,** daß zur Positionierung der Leiterplatten (Lp) im oberen Nadeladapter (Nao) mindestens zwei den oberen Andruckstößeln (Aso) vorauseilende Zentrierstifte (Zs) angeordnet sind.

## Claims

1. Test device for fitted printed-circuit boards (Lp) by means of double-sided contacting, in each case in two stages, in four successive contacting stages (St 1, St 2, St 3, St 4), having
   - a lower needle adaptor (Nau), which carries first and second sprung contact needles (Kn 1, Kn 2) which are arranged specifically for the item under test and are of different length for two-stage contacting with the lower sides of printed-circuit boards (Lp),
   - an upper needle adaptor (Nao), which carries third and fourth sprung contact needles (Kn 3, Kn 4), which are arranged specifically for the item under test, and are of different length for two-stage contacting with the upper sides of the printed-circuit boards (Lp),
   - a plurality of lower pressure rams (Asu), arranged specifically for the item under test, and having
   - a plurality of upper pressure rams (Aso), arranged specifically for the item under test,
   - the printed-circuit boards (Lp) being clamped in between the lower pressure rams (Asu) and the upper pressure rams (Aso).

2. Test device according to Claim 1, characterised in that the lower needle adaptor (Nau) is arranged in a fixed position.

3. Test device according to Claim 2, characterised in that the printed-circuit boards (Lp) can be pressed by means of upper pressure rams (Aso), of sprung construction, against the lower needle adaptor (Nau), which is arranged in a fixed position, the forces of the sprung, upper pressure rams (Aso) being greater in total than the sum of the spring forces of the third and fourth contact needles (Kn3, Kn4).

4. Test device according to one of the preceding claims, characterised in that the upper needle adaptor (Nao) is arranged such that it can be displaced in the vertical direction.

5. Test device according to Claims 3 and 4, characterised in that the sprung, upper pressure rams (Aso) are fixedly arranged in the upper needle adaptor (Nao).

6. Test device according to one of the preceding claims, characterised in that the lower pressure rams (Asu) can be displaced in two stages in the vertical direction.

7. Test device according to Claim 6, characterised in that the lower pressure rams (Asu) are guided in the lower needle adaptor (Nau) and can be operated via a lower, common pressure plate (Dp).

8. Test device according to one of the preceding claims, characterised in that at least two centring pins (Zs), which project beyond the upper pressure rams (Aso), are arranged in the upper needle adaptor (Nao) for positioning of the printed-circuit boards (Lp).

## Revendications

1. Dispositif de test pour des plaquettes à circuits imprimés (Lp) équipées au moyen de l'établissement d'un contact bilatéral, respectivement en deux étapes, au cours de quatre étapes de contact successives (St 1, St 2, St 3, St 4), comportant
   - un adaptateur inférieur à aiguilles (Nau), qui porte des premières et secondes aiguilles de contact suspendues élastiquement (Kn 1, Kn 2) disposées d'une manière spécifique à l'objet à tester et possédant des longueurs différentes pour établir un contact en deux étapes avec les faces inférieures des plaquettes à circuits imprimés (Lp),
   - un adaptateur supérieur à aiguilles (Nao) qui porte des troisièmes et quatrièmes aiguilles de contact suspendues élastiquement (Kn 3, Kn 4) disposées d'une manière spécifique à l'objet à tester et possédant des longueurs différentes pour l'établissement d'un contact en deux étapes sur les faces supérieures des plaquettes à circuits imprimés (Lp),
   - plusieurs poussoirs inférieurs de serrage (Asu) disposés d'une manière spécifique à l'objet à tester et comportant
   - plusieurs poussoirs supérieurs de serrage (Aso) disposés d'une manière spécifique à l'objet à tester,
   - les plaquettes à circuits imprimés (Lp) étant serrées entre les poussoirs inférieurs de serrage (Asu) et les poussoirs supérieurs de serrage (Aso).

2. Dispositif de test suivant la revendication 1, caractérisé par le fait que l'adaptateur inférieur à aiguilles (Nau) est monté fixe.

3. Dispositif de test suivant la revendication 2, caractérisé par le fait que les plaquettes à circuits imprimés (Lp) peuvent être repoussées au moyen de poussoirs supérieurs de serrage (Aso) agencés de manière à être élastiques, contre l'adaptateur inférieur à aiguilles (Nau) monté fixe, la somme des forces des poussoirs supérieurs élastiques de serrage (Aso) étant supérieure à la somme des forces élastiques des troisièmes et quatrièmes aiguilles de contact (Kn3, Kn4).

4. Dispositif de test suivant l'une des revendications précédentes, caractérisé par le fait que l'adaptateur supérieur à aiguilles (Nao) est disposé de manière à être déplaçable dans une direction verticale.

5. Dispositif de test suivant l'une des revendications précédentes, caractérisé par le fait que les poussoirs supérieurs élastiques de serrage (Aso) sont montés fixes dans l'adaptateur supérieur à aiguilles (Nao).

6. Dispositif de test suivant l'une des revendications précédentes, caractérisé par le fait que les poussoirs inférieurs de serrage (Asu) peuvent être déplacés dans une direction horizontale en deux étapes.

7. Dispositif de test suivant l'une des revendications précédentes, caractérisé par le fait que les poussoirs inférieurs de serrage (Asu) sont guidés dans l'adaptateur inférieur à aiguilles (Nau) et peuvent être actionnés par l'intermédiaire d'une plaque de pression inférieure commune (Dp).

8. Dispositif de test suivant l'une des revendications précédentes, caractérisé par le fait que pour le positionnement des plaquettes à circuits imprimés (Lp), au moins deux broches de centrage (Zs), qui sont en avance par rapport aux poussoirs supérieurs de serrage (Aso), sont disposées dans l'adaptateur supérieur à aiguilles (Nao).

## FIG 1

## FIG 2